**Europäisches Patentamt**

**European Patent Office**

**Office européen des brevets**

(19)

(11) **EP 1 045 461 A2**

(12) **EUROPÄISCHE PATENTANMELDUNG**

(43) Veröffentlichungstag:
    **18.10.2000 Patentblatt 2000/42**

(51) Int. Cl.[7]: **H01L 43/14**

(21) Anmeldenummer: **00810082.8**

(22) Anmeldetag: **28.01.2000**

(84) Benannte Vertragsstaaten:
    **AT BE CH CY DE DK ES FI FR GB GR IE IT LI LU MC NL PT SE**
    Benannte Erstreckungsstaaten:
    **AL LT LV MK RO SI**

(30) Priorität: **01.02.1999 CH 174992000**
    **21.10.1999 CH 194099**

(71) Anmelder: **SENTRON AG**
    **6300 Zug (CH)**

(72) Erfinder:
    • **Popovic, Radivoje Dr.**
      **6300 Zug (CH)**
    • **Randjelovic, Zoran**
      **1004 Lausanne (CH)**
    • **Racz, Robert**
      **6300 Zug (CH)**

(74) Vertreter: **Falk, Urs, Dr.**
    **Patentanwaltsbüro Dr. Urs Falk,**
    **Eichholzweg 9A**
    **6312 Steinhausen (CH)**

(54) **Verfahren zur Herstellung von Hallelementen**

(57) Bei der Herstellung von Halbleiterelementen wird üblicherweise durch Implantation und nachfolgende Diffusion innerhalb eines Gebietes (7) eines ersten Leitfähigkeittyps ein zusammenhängendes Gebiet (6) eines zweiten Leitfähigkeittyps gebildet wird. Erfindungsgemäss werden bei der Implantation mindestens zwei voneinander getrennte Gebiete des zweiten Leitfähigkeittyps gebildet, deren Abstand so bemessen ist, dass sich die mindestens zwei Gebiete bei der Diffusion zu dem zusammenhängenden Gebiet vereinigen. Dank der Erfindung lassen sich Hallelemente (3) mit verbesserten Eigenschaften ohne Prozessänderung auf einem Elektronikchip integrieren.

Fig.2

Fig.1

EP 1 045 461 A2

**Beschreibung**

Die Erfindung betrifft ein Verfahren zur Herstellung von Hallelementen der im Oberbegriff des Anspruchs 1 genannten Art.

IC-Technologien sind optimiert für den einer Bausteinfamilie zugrundeliegenden Halbleiterschaltkreis. Die CMOS Technologie beispielsweise ist optimiert zur Erzielung der besten Eigenschaften von MOS Transistoren. Die Realisierung von Komponenten, z.B. von Sensoren, die nicht zur Standardreihe der Bausteinfamilie gehören, ist daher nur möglich durch Eingehen von Kompromissen, die die Leistungsfähigkeit dieser Komponente schmälern, oder durch Inkaufnahme erhöhter Kosten. Die Integration eines als Magnetfeldsensor dienenden Hallelementes in einen CMOS Baustein z.B. ist auf drei Arten möglich:

a) Verwendung der n-Wanne für die Realisierung des aktiven Gebietes des Hallelementes. Der Nachteil dieser Lösung liegt darin, dass die Dotierung der n-Wanne relativ gross ist, so dass die Empfindlichkeit des Hallelementes weit unter dem wünschbaren Wert liegt.

b) Hinzufügen einer speziellen, tief dotierten n-Schicht, zum CMOS Prozess. Diese Lösung ist teuer.

c) Verwendung einer Hybridschaltung, die zwei getrennte Halbleiterchips aufweist, wobei der eine Halbleiterchip als Hallelement ausgebildet ist und wobei der andere Halbleiterchip die Elektronik für die Verarbeitung des Hallsignales enthält. Auch diese Lösung ist teuer.

Der Erfindung liegt die Aufgabe zugrunde, ein Verfahren zur Herstellung von Hallelementen anzugeben, bei dem sich das Hallelement auf demselben Chip befindet wie die Elektronik, ohne dass zusätzliche Prozessschritte erforderlich sind.

Die Erfindung besteht in den im Anspruch 1 angegebenen Merkmalen. Vorteilhafte Ausgestaltungen ergeben sich aus den abhängigen Ansprüchen.

Bei der Herstellung von Halbleiterelementen wird üblicherweise durch Implantation und nachfolgende Diffusion innerhalb eines Gebietes eines ersten Leitfähigkeittyps ein zusammenhängendes Gebiet eines zweiten Leitfähigkeittyps gebildet. Form und Grösse des Gebietes des zweiten Leitfähigkeittyps ändern sich bei der nachfolgenden Diffusion nur in unbedeutendem Masse. Erfindungsgemäss wird nun bei der Implantation für das Gebiet des zweiten Leitfähigkeittyps eine Maske verwendet, bei der ein grösserer Teil der Fläche des Gebietes des zweiten Leitfähigkeittyps, die dieses Gebiet nach der nachfolgenden Diffusion bzw. den nachfolgenden Diffusionen einnimmt, abgedeckt ist. So ist es z.B. besonders vorteilhaft, bei der Implantation mindestens zwei voneinander getrennte Gebiete des zweiten Leitfähigkeittyps zu bilden, deren Abstand so bemessen ist, dass sich die mindestens zwei Gebiete bei der Diffusion zu dem zusammenhängenden Gebiet vereinigen. Die effektive Dichte der implantierten Ionen und damit der beweglichen Ladungsträger - Elektronen oder Löcher - lässt sich damit entsprechend dem Verhältnis von abgedeckter Fläche zur Gesamtfläche des Gebietes des zweiten Leitfähigkeittyps reduzieren. Dank der Erfindung lassen sich so beispielsweise Hallelemente ohne die oben genannten Nachteile auf einem Elektronikchip integrieren. Eine andere Möglichkeit zur Erhöhung der Empfindlichkeit eines Hallelementes, ohne eine Prozessänderung in Kauf nehmen zu müssen, besteht darin, bei der Implantation des später als magnetfeldempfindliche Zone dienenden Gebietes eine Maske mit zwei gekreuzt angeordneten Schlitzen zu verwenden, die sehr schmal im Vergleich zur Tiefe des Gebietes nach der Diffusion sind. Bei der Diffusion verbreitert sich das Gebiet des zweiten Leitfähigkeittyps infolge der seitlichen Diffusion sehr stark. Die effektive Ladungsträgerdichte, die die Empfindlichkeit des Hallelementes massgeblich bestimmt, wird somit bei der Diffusion wesentlich verkleinert.

Nachfolgend werden Ausführungsbeispiele der Erfindung anhand der Zeichnung näher erläutert.

Es zeigen:

Fig. 1 Implantationsmasken für ein Hallelement,

Fig. 2 das Hallelement im Querschnitt, und

Fig. 3, 4 weitere Implantationsmasken für weitere Hallelemente.

Der Beschreibung der Erfindung liegen die in der Herstellung von Halbleiterelementen geläufigen Begriffe zugrunde. Die Beschreibung beschränkt sich zudem auf die Darlegung der erfindungswesentlichen Merkmale.

Beispiel 1

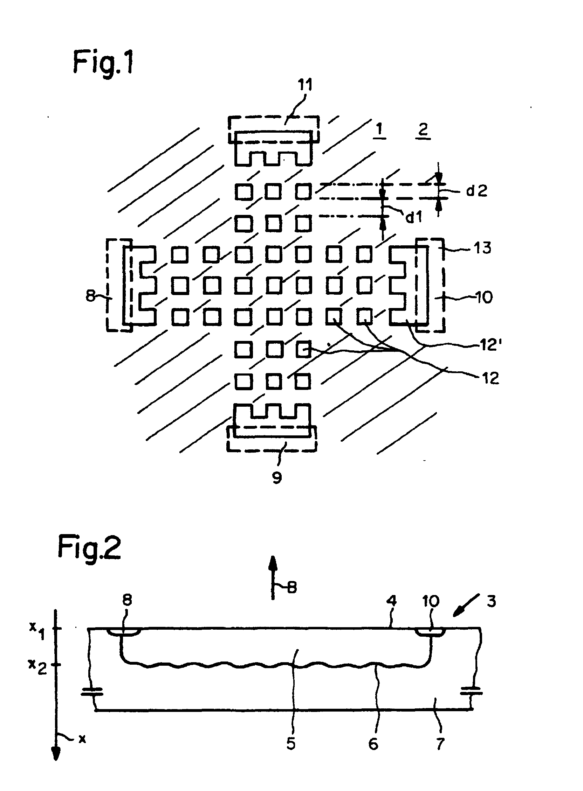

Die Fig. 1 zeigt in der Draufsicht das Layout von zwei Masken 1 und 2 für ein kreuzförmiges Hallelement, die bei der Herstellung des Hallelementes als Implantationsmasken dienen. Die Fig. 2 zeigt das fertige Hallelement 3 im Querschnitt. Das Hallelement 3 dient zur Messung eines seine Oberfläche 4 in senkrechter Richtung durchflutenden Magnetfeldes B und ist beispielsweise in einer CMOS oder Bipolar-Technologie hergestellt. Als Substrat dient ein Siliziumsubstrat 7 eines eines ersten Leitfähigkeittyps. Das Hallelement 3 umfasst ein der Messung des Magnetfeldes B dienendes Gebiet 5, das als Wanne 6 eines zweiten Leitfähigkeittyps im Siliziumsubstrat 7 realisiert ist, und vier Elektroden 8 - 11. Über die vier Elektroden 8 - 11, die als hochdotierte Gebiete des zweiten Leitfähigkeittyps ausgebildet sind, ist die Wanne 6 elektrisch kontaktiert. Die zwei einander gegenüberliegenden Elektroden 8 und 10 dienen als Stromkontakte zur Einspeisung eines Stromes I. Die Elektroden 9 und 11 dienen als Spannungselektroden zum Abgreifen der sich zwischen ihnen bei Anwesenheit des Magnetfeldes B einstellenden Hallspannung $U_H$.

Die Hallspannung $U_H$ in Funktion des durch das Hallelement 3 fliessenden Stromes I und des Magnetfeldes B und die strombezogene Empfindlichkeit $S_I$ des Hallelementes 3 sind gegeben durch

$$U_H = S_I * I * B \text{ und } S_I = G\frac{r_H}{q*N_S} ,$$

wobei G einen von der Geometrie des Hallelementes 3 abhängigen Korrekturfaktor, $r_H$ den mittleren Hall Streufaktor, q die Elementarladung und $N_S$ die auf eine Flächeneinheit bezogene Dichte der freien Ladungsträger in der Wanne 6 bezeichnen. Die Grösse $N_S$ ist gegeben durch

$$N_S = \int\limits_{x1}^{x2} n(x)dx$$

wobei n(x) die lokale Dichte der freien Ladungsträger im aktiven Gebiet in Funktion der Tiefe x bezeichnet.

Die Wanne 6 ist bevorzugt eine n-dotierte Wanne, da die Beweglichkeit der Elektronen grösser als die Beweglichkeit der Löcher ist. Für ein in einer Standard CMOS Technologie hergestelltes Hallelement mit einer n-Wanne als magnetfeldempfindlichem Gebiet 5 erhält man mit $G \cong 0.7$, $r_H \cong 1.1$, $q = 1.6*10^{-19}$ C und $N_S \cong 8*10^{12}$ cm$^{-2}$: $S_I \cong 60$ V/AT

Die n-Wanne 6 wird durch einen Implantations- und anschliessenden Diffusionsprozess hergestellt. Die Grösse $N_S$ ist daher gleich der Anzahl der pro Flächeneinheit implantierten Ionen, der implantierten Dosis Q.

Die Erfindung besteht nun darin, für die Implantation einen vergleichsweise grossen Anteil der Oberfläche der für das Hallelement 3 zu bildenden n-Wanne 6 abzudecken. Die für die Erstellung der n-Wanne benützte Maske 1 (Fig. 1) weist deshalb beim Hallelement 3 nicht ein einziges grosses Fenster, dessen Umriss der Form des Hallelementes 3 (Kreuzform in Fig. 1) entspricht, sondern eine Vielzahl von kleinen Fenstern 12 auf. Die Abstände $d_1$ zwischen den Fenstern 12 sind kleiner als die Tiefe $x_2$, die die n-Wanne 6 während des der Implantation folgenden Diffusionsprozesses (und allenfalls weiterer Diffusionsprozesse) erreicht. Da der Abstand $d_1$ zwischen den Fenstern 12 kleiner als die Distanz $x_2$ ist, bildet sich beim Diffusionsprozess infolge der auch seitlich erfolgenden Diffusion eine zusammenhängende n-Wanne. Die kleinen Fenster 12 sind, wie in der Fig. 1 dargestellt, derart matrixartig nebeneinander angeordnet, dass sich bei der Diffusion als magnetfeldempfindliches Gebiet die zusammenhängende n-Wanne 6 bildet.

Bei einer n-Wannen CMOS Technologie beträgt die Tiefe $x_2$ der n-Wannen 6 beispielsweise etwa 1 - 2 μm. Mit quadratischen Fenstern 12, deren lineare Abmessungen $d_2$ 0.8μm betragen und deren gegenseitiger Abstand $d_1$ ebenfalls 0.8μm beträgt, lässt sich die in das Siliziumsubstrat 7 implantierte Dosis um den Faktor 4 verringern, da während der Implantation gegenüber herkömmlichen Herstellungsverfahren drei Viertel des magnetfeldempfindlichen Gebietes 5 des Hallelementes 3 abgedeckt sind. Die effektiv wirksame Dosis $Q_{eff}$ ist also um einen Faktor 4 kleiner als die vom Implanter gelieferte Dosis Q. Folglich ist die Dichte der freien Ladungsträger $N_S$ in der Wanne 6 auch um den Faktor 4 kleiner und die strombezogene Empfindlichkeit $S_I$ des derart hergestellten Hallelementes 3 um etwa einen Faktor 4 grösser.

Der Abstand $d_1$ könnte auch etwas grösser als die Distanz $x_2$ gewählt werden, da die seitliche Diffusion ja immer von zwei benachbarten Fenstern 12 ausgeht, wobei sich die Diffusionsfronten in der Mitte zwischen den Fenstern 12 treffen und damit den elektrischen Zusammenschluss zu einer einzigen n-Wanne 6 bewirken.

Durch das gezielte Ausnutzen der seitlichen Diffusion kann somit ohne zusätzliche Prozessschritte ein Hallelement hoher Empfindlichkeit und die für den Betrieb des Hallelementes erforderliche Elektronik auf dem gleichen Chip realisiert werden.

In der Fig. 1 ist mit gestrichelten Linien das Layout der Maske 2 dargestellt, die bei der Implantation der Elektroden 8 - 11 benutzt wird. Die Fenster 12 der Maske 1, die den Fenstern 13 benachbart sind, sind miteinander zu einem grösseren Fenster 12' verbunden, damit ein bei der Herstellung innerhalb bestimmter Toleranzgrenzen vorkommendes Misalignment zwischen den Masken 1 und 2 möglichst geringe Offsetfehler verursacht.

Die Erfindung lässt sich nicht nur für die Erhöhung der Empfindlichkeit eines im Elektronikchip integrierten Hallelementes benutzen. Die Erfindung kann auch benutzt werden, um auf dem gleichen Chip n-Wannen unterschiedlicher Leitfähigkeit herzustellen, die z.B. als Widerstände mit unterschiedlichem Widerstandswert verwendet werden können.

Beispiel 2

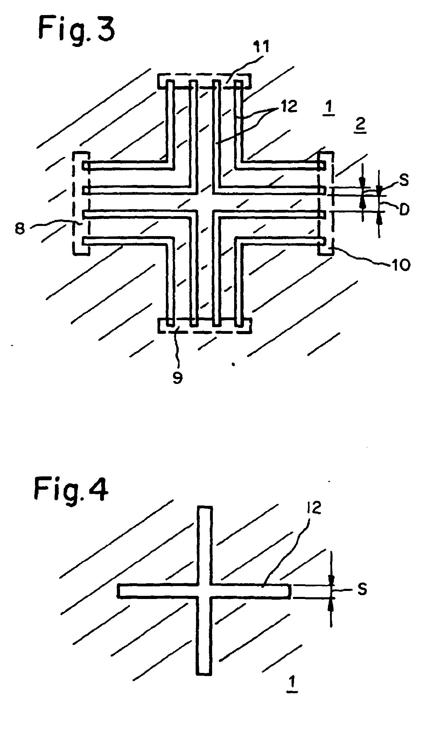

Die Fig. 3 zeigt das Layout der bei der Implantation zu verwendenden Masken 1 und 2 für ein weiteres Hallelement 3. Bei der Maske 1, die für die Dotierung des magnetfeldempfindlichen Gebietes des Hallelementes 3, hier der n-Wanne 6 (Fig. 2), benutzt wird, weisen die Fenster 12 die Form von Schlitzen auf. Die Breite S der Schlitze ist kleiner als die Tiefe $x_2$, die die n-Wanne 6 bei den nachfolgenden Diffusionen erreicht. Mit gestrichelten Linien sind die Fenster in der Implantationsmaske 2 dargestellt, die für die Dotierung der Elektroden 8 - 11 vorgesehen sind. Der Abstand D der Schlitze beträgt etwa das ein bis zweifache der Tiefe $x_2$. Der Abstand D ist jedoch maximal so gross gewählt, dass sich bei den nachfolgenden Diffusionen eine einzige zusammenhängende n-Wanne 6 bildet. Der Vorteil besteht auch hier darin, dass die effektiv wirksame Dosis $Q_{eff}$ markant kleiner als die vom Implanter gelieferte Dosis Q ist.

Beispiel 3

Die Fig. 4 zeigt das Layout der bei der Implantation zu verwendenden Maske 1 für ein kreuzförmiges Hallelement 3, das durch nur zwei Schlitze (Fenster 12) gebildet ist, deren Breite S wesentlich kleiner als die Tiefe $x_2$ ist. Bei den nachfolgenden Diffusionsprozessen diffundieren die implantierten Ionen sowohl in die Tiefe also auch in seitlicher Richtung, so dass die n-Wanne 6 schliesslich die Breite $B = S + 2 * k * x_2$ erreicht, wobei der numerische Parameter k einen Wert etwas kleiner als 1, typisch $k \cong 0.8$ aufweist. Die Dichte der freien Ladungsträger $N_S$, die etwa gleich der effektiv wirksamen Dosis $Q_{eff}$ ist, die ergibt sich daher zu

$$N_S = \frac{S}{S+2*k*x_2}Q.$$

Die Vorteile eines solchen Hallelementes sind:

- Die strombezogene Empfindlichkeit des Hallelementes $S_I$ erhöht sich gegenüber einem konventionellen Hallelement, dessen n-Wanne um ein Vielfaches breiter als seine Tiefe $x_2$ ist, um etwa den Faktor

$$\frac{S+2*k*x_2}{S}.$$

- Das magnetfeldempfindliche Volumen des Hallelementes wird äusserst klein, so dass das Magnetfeld mit hoher örtlicher Auflösung gemessen werden kann.

**Patentansprüche**

1. Verfahren zur Herstellung eines Hallelementes (3), bei dem durch Implantation und eine oder mehrere nachfolgende Diffusionen innerhalb eines Gebietes eines ersten Leitfähigkeittyps (7) ein zusammenhängendes Gebiet (6) eines zweiten Leitfähigkeittyps gebildet wird, **dadurch gekennzeichnet, dass** bei der Implantation mindestens zwei voneinander getrennte Gebiete des zweiten Leitfähigkeittyps gebildet werden, deren Abstand so bemessen ist, dass sich die mindestens zwei Gebiete bei der nachfolgenden oder den nachfolgenden Diffusionen zu dem zusammenhängenden Gebiet (6) vereinigen.

2. Verfahren nach Anspruch 1, **dadurch gekennzeichnet, dass** bei der Implantation zur Bildung des zusammenhängenden Gebietes (6) des zweiten Leitfähigkeittyps eine Maske (1) mit Fenstern (12) verwendet wird, deren Abmessungen kleiner als die Tiefe ($x_2$) des zusammenhängenden Gebietes (6) nach der nachfolgenden oder den nachfolgenden Diffusionen ist.

3. Verfahren nach Anspruch 1, **dadurch gekennzeichnet, dass** bei der Implantation zur Bildung des zusammenhängenden Gebietes (6) des zweiten Leitfähigkeittyps eine Maske (1) mit Fenstern (12) verwendet wird, die als Schlitze ausgebildet sind, deren Breite (S) kleiner als die Tiefe ($x_2$) des zusammenhängenden Gebietes (6) nach der nachfolgenden oder den nachfolgenden Diffusionen ist.

4. Verfahren zur Herstellung eines Hallelementes (3), bei dem durch Implantation und nachfolgende Diffusion innerhalb eines Gebietes eines ersten Leitfähigkeittyps (7) ein zusammenhängendes Gebiet (6) eines zweiten Leitfähigkeittyps gebildet wird, **dadurch gekennzeichnet, dass** bei der Implantation eine Maske mit zwei kreuzförmig angeordneten Schlitzen verwendet wird, wobei die Breite (S) der Schlitze kleiner als die Tiefe ($x_2$) ist die das Gebiet (6) des zweiten Leitfähigkeittyps nach der nachfolgenden oder den nachfolgenden Diffusionen aufweist.

## Fig.1

## Fig.2

# Fig. 3

# Fig. 4